# EUROPÄISCHE PATENTSCHRIFT

(11) **EP 1 116 042 B1**
(45) Veröffentlichungstag und Bekanntmachung des Hinweises auf die Patenterteilung: **12.03.2003**
(21) Anmeldenummer: 99948884.4
(22) Anmeldetag: 28.09.1999
(51) Int. Cl.: G01R 31/3185

(54) **SCHALTUNGSANORDNUNG MIT DEAKTIVIERBAREM SCANPFAD**
CIRCUIT CONFIGURATION WITH A SCAN PATH THAT CAN BE DEACTIVATED
CIRCUITERIE A CHEMIN DE BALAYAGE DESACTIVABLE

(30) Priorität: 28.09.1998 EP 98118302
(43) Veröffentlichungstag der Anmeldung: 18.07.2001
(73) Patentinhaber: Infineon Technologies AG, 81669 München (DE)
(72) Erfinder: PALM, Herbert, D-85635 Höhenkirchen (DE); SMOLA, Michael, D-80636 München (DE); WALLSTAB, Stefan, D-81739 München (DE)
(74) Vertreter: Epping Hermann & Fischer
(86) Internationale Anmeldenummer: EP9907189
(87) Internationale Veröffentlichungsnummer: WO00019224

(56) Entgegenhaltungen:
- US-A- 5 530 749
- US-A- 5 627 478

## Beschreibung

Die Erfindung betrifft eine Schaltungsanordnung mit einer Anzahl von Funktionsblöcken, wobei jeder des Funktionsblöcke mit zumindest einem der anderen Funktionsblöcke verbunden ist und zumindest eine Teilmenge dieser Verbindungen über ein Verriegelungselement realisiert ist, das über eine Aktivierleitung vom Normal- in einen Testmodus umgeschaltet werden kann und das einen weiteren Datenein- und einen Datenausgang aufweist und diese weiteren Datenein- und -ausgänge mittels Datenleitungsabschnitten derart miteinander verbunden sind, daß die Verriegelungselemente ein einen Scanpfad realisierendes Schieberegister bilden.

Ein solche Schaltungsanordnung ist aus der US 4,534,028 bekannt. Der dort beschriebene in der Schaltungsanordnung realisierte Scanpfad dient dem vereinfachten Testen der Funktionsblöcke der Schaltungsanordnung, da durch die zu einem Schieberegister zusammenschaltbaren Verriegelungselemente, die dort als Flip-Flops ausgebildet sind, die einzelnen Funktionsblöcke zu definierten Zeitpunkten mit definierten Eingangszuständen beaufschlagt werden können und auch die in den Verriegelungselementen gespeicherten Zwischenergebnisse über das Schieberegister wieder ausgelesen werden können. Ein Funktionsblock soll dabei eine Schaltungseinheit sein, die eine bestimmte für sich testbare Funktion erfüllt.

Bestimmte Formen elektronischer Schaltungen wie zum Beispiel Schaltungen für Chipkarten erfordern ein hohes Maß an Geheimhaltung von Schaltungsinformationen und chipinternen Daten wie zum Beispiel Schlüssel für kryptologische Verfahren. Diese sicherheitsrelevanten Informationen müssen sowohl vor Fremdanalysen als auch vor Manipulation geschützt werden. Gleichzeitig erfordert der Schaltungsentwurf ein Mindestmaß an Transparenz und Zugang zu solchen sicherheitsrelevanten Schaltungsblöcken und Daten um eine ausreichende Zuverlässigkeit durch Testen sicherzustellen. Um ein hohes Maß an Testabdeckung während bzw. nach der Produktion zu gewährleisten werden häufig zusätzlich Testkomponenten wie zum Beispiel der oben beschriebene Scanpfad in die elektronische Schaltung integriert, die es ermöglichen, einen Funktionsblock in nahezu alle gewünschten Zustände zu versetzen, um ihn so auf dessen Funktionalität hin zu prüfen.

Die zum Test eingefügten Komponenten werden dabei oft durch zentrale Testcontroller aktiviert bzw. deaktiviert. Diese Testcontroller werden entweder durch Software oder durch externe Signale über spezielle Testpins aktiviert. Beide Varianten sind relativ einfach zu manipulieren und bilden damit ein potentielles Sicherheitsrisiko. Damit sind die bisher eingesetzten Verfahren zur Steigerung der Analysierbarkeit von integrierten Schaltungen nicht vereinbar mit der heute geforderten hohen Sicherheit spezieller elektronischer Bauteile.

Es ist bereits bekannt, spezielle Funktionsblöcke einer Schaltungsanordnung nach einem Test bzw. einer ersten Inbetriebnahme irreversibel von der restlichen Schaltung abzutrennen.

So ist in der Anmeldung DE 197 11 478 A1 bereits beschrieben, ein Test-ROM nur über einen irreversibel einstellbaren Multiplexer auslesen zu können, um somit einen Zugriff auf das Test-ROM nach dem Test zu verhindern.

Die DE 27 38 113 A1 offenbart bereits, den Zugriff auf Speicher mit sicherheits- bzw. funktionsrelevantem Inhalt durch zerstörbare Tore irreversibel zu verhindern.

Diese bekannten Anordnungen haben jedoch den Nachteil, daß die irreversibel einstellbaren oder zerstörbaren Schaltungsbestandteile an leicht auffindbaren Stellen angeordnet sind und relativ leicht "repariert" werden können und so eine umfangreiche Analyse und damit eine Manipulation ermöglichen.

Die der Erfindung zugrunde liegende Aufgabe ist daher, eine gattungsgemäße Schaltungsanordnung derart weiterzubilden, daß eine mißbräuchliche Analyse mittes des Scanpfads nahezu unmöglich ist.

Die Aufgabe wird durch eine Schaltungsanordnung gemäß Anspruch 1 gelöst. Vorteilhafte Weiterbildungen sind in den Unteransprüchen angegeben.

Die Verriegelungselemente eines Scanpfads sind über die gesamte Chipfläche verteilt. Somit verlaufen auch die Aktivierund eine aus den Datenleitungsabschnitten zusammengesetzte Datenleitung über die gesamte Chipfläche. Damit sind aber auch die Sicherungselemente dezentral über die Fläche des Chips verteilt, so daß die Sicherheit gegen "Angriffe" sehr hoch ist. Durch geeignete Wahl der Technologie wird darüber hinaus eine sehr hohe Sicherheit gegen Reprogrammierung der Sicherungselemente erreicht. Beispiele für solche Sicherungselemente sind in der DE 196 04 776 A1 angegeben.

Die Wahl unterschiedlicher Sicherungselemente als durchtrennbare oder erzeugbare Leitungsabschnitte das heißt als "Fuses" oder als "Anti-Fuses" erhöht die Sicherheit, da ein "Angreifer" nicht auf Anhieb erkennt, welche Art von Elementen benutzt wird. Sehr vorteilhaft ist auch die Verwendung beider Arten. Die Sicherheitselemente können auch in Verbindung mit logischen Gattern verwendet werden, um diese durch Festlegen des Potential an einem Eingang in ihrer Funktion als offene oder geschlossene Schalter zu definieren.

Die Erfindung wird nachfolgend anhand von Ausführungsbeispielen mit Hilfe von Figuren näher erläutert. Dabei zeigen:
- Figur 1: eine erfindungsgemäße Schaltungsanordnung und
- Figur 2: Ausführungsbeispiele für Sicherungslelemente.

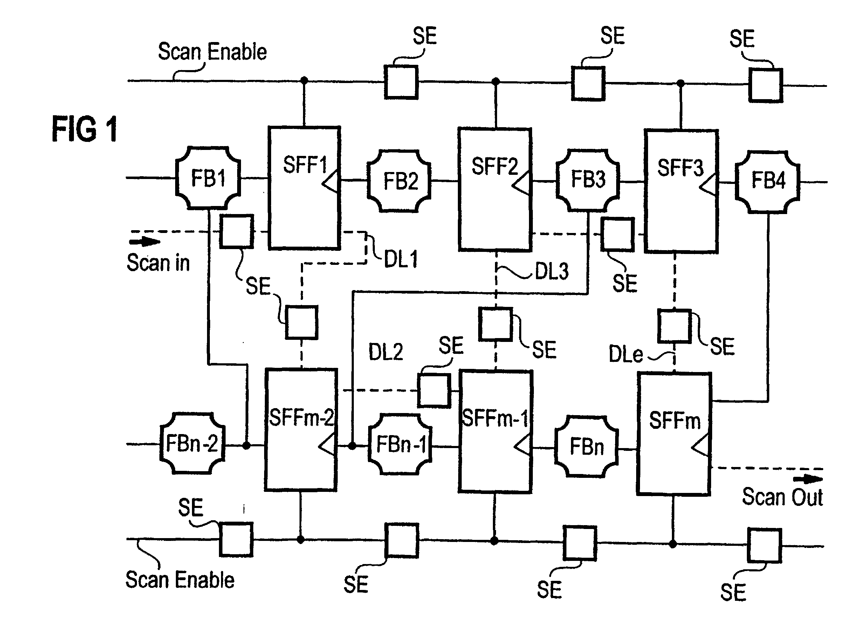

Die Schaltungsanordnung gemäß Figur 1 zeigt Funktionsblöcke FB1...FBn die direkt oder über Verbindungselemente SFF1...SFFm miteinander verbunden sind. Ein Funktionsblock kann dabei mit einem oder mit mehreren anderen Funktionsblökken verbunden sein. Die Verbindung kann dabei direkt oder über Verbindungselemente erfolgen. Die Verbindungselemente SFF1...SFFm sind meist als spezielle Flip-Flops - Scan-Flip-Flops genannt - ausgebildet.

Die Verbindungselemente SFF1...SFFm sind darüber hinaus über eine Aktivierleitung Scan Enable vom Normalbetrieb, in dem sie die Weiterleitung vom Ausgang eines Funktionsblocks zum Eingang des nachfolgenden Funktionsblocks übernehmen, in einen Testbetrieb umschaltbar. Für den Testbetrieb weisen sie einen weiteren Ein- und einen weiteren Ausgang auf. Über diese Ein- und Ausgänge werden sie mittels strichliert dargestellter Datenleitungsabschnitte DL1...DLl zu einem Schieberegister miteinander verbunden. Im Testbetrieb ist es damit möglich, Daten über den Schieberegistereingang Scan In in die Verbindungselemente SSF1...SSFm zu laden, um dann durch Umschalten in den Normalbetrieb mittels eines einzigen Taktimpulses die Funktionsblöcke FB1...FBn mit den zuvor in das Schieberegister geladenen Daten zu beaufschlagen. Die Ausgangsdaten der Funktionsblöcke FB1...FBn werden in die einem jeweiligen Funktionsblock nachgeschalteten Verbindungselemente geladen und können durch Umschalten in den Testmodus über das Schieberegister und dessen Ausgang Scan Out ausgelesen werden. Mittels dieses Scanpfads kann jeder Funktionsblock FB1...FBn in jeden beliebigen Zustand gebracht und einzeln getestet werden.

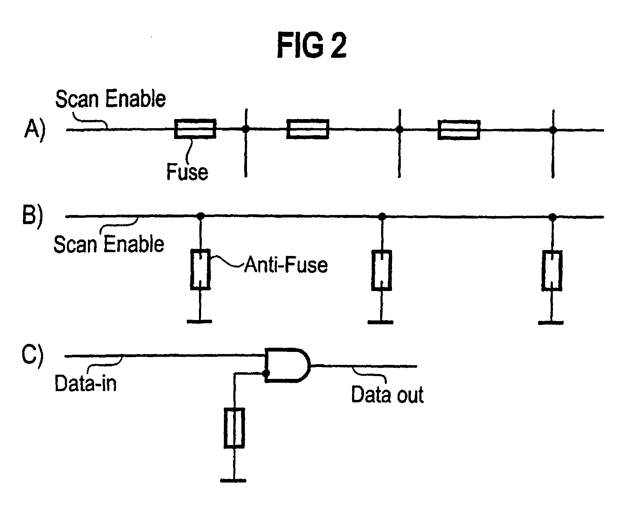

In erfindungsgemäßer Weise sind sowohl in der Aktivierleitung Scan Enable als auch in der die Verbindungselemente SSF1...SSFm verbindenen Datenleitung DL1...DLl Sicherungselemente SE angeordnet. Diese können, wie in Figur 2 dargestellt ist, sowohl als durchtrennbare Sicherungen, "Fuses", oder erzeugbare Verbindungen, die beispielsweise einen Massekurzschluß bewirken oder die Leitung ständig mit dem Versorgungsspannungspotential verbinden, "Anti-Fuses",realisiert sein und als weitere Möglichkeit mit diesen Eigenschaften in Verbindung mit einem logischen Gatter dieses in einer festen Funktion verriegeln. Diese Sicherungselemente SE sind dezentral über die gesamte Chipfläche verteilt und ermöglichen nach dem Test ein vielfaches Durchtrennen oder Kurzschließen der Aktivierleitung Scan Enable als auch der Datenleitungsabschitte DL1...DLl und damit des Scanpfads.

## Patentansprüche

1. Schaltungsanordnung mit einer Anzahl von Funktionsblöcken (FB1...FBn), wobei jeder der Funktionsblöcke mit zumindest einem der anderen Funktionsblöcke verbunden ist und zumindest eine Teilmenge dieser Verbindungen über je ein Verriegelungselement (SFF1...SFFm) realisiert ist, das über eine Aktivierleitung (Scan Enable) vom Normal- in einen Testmodus umgeschaltet werden kann und das einen weiteren Datenein- und einen Datenausgang aufweist und diese weiteren Datenein- und-ausgänge mittels Datenleitungsabschnitte (DL1...DLl) derart miteinander verbunden sind, daß die Verriegelungselemente (SFF1...SFFm) ein einen Scan-Pfad realisierendes Schieberegister bilden,
**dadurch gekennzeichnet,**
**daß** entlang der Aktivierleitung (Scan Enable) und/oder der Datenleitungsabschnitte (DL1...DLl) zumindest ein elektrisch programmierbares Sicherungselement (SE) angeordnet ist, das die betreffende Leitung entweder unterbricht oder mit einem definierten Potential verbindet.

2. Schaltungsanordnung nach Anspruch 1, **dadurch gekennzeichnet, daß** zumindest ein Sicherungselement (SE) ein elektrisch durchtrennbarer Leitungsabschnitt (Fuse) ist und in der betreffenden Leitung angeordnet ist.

3. Schaltungsanordnung nach Anspruch 1 oder 2, **dadurch gekennzeichnet, daß** zumindest ein Sicherungselement (SE) ein elektrisch erzeugbarer Leitungsabschnitt (Anti-Fuse) ist und zwischen der betreffenden Leitung und dem definierten Potential angeordnet ist.

4. Schaltungsanordnung nach einem der vorangehenden Ansprüche, **dadurch gekennzeichnet, daß** zumindest ein Sicherungselement (SE) mit einem in der betreffenden Leitung angeordneten logischen Gatter gebildet ist, dessen zweiter Eingang mittels eines elektrisch durchtrennbaren oder erzeugbaren Leitungsabschnitts irreversibel auf ein definiertes Potential gelegt werden kann, so daß das Gatter sperrt.

## Claims

1. Circuit arrangement having a number of function blocks (FB1...FBn), in which case each of the function blocks is connected to at least one of the other function blocks, and at least one subset of these connections is in the form of a respective interlocking element (SFF1...SFFm) which can be switched via an activation line (Scan Enable) from the normal mode to a test mode and which has a further data input and a data output, and these further data inputs and outputs are connected to one another by means of data line sections (DL1...DLl) in such a manner that the interlocking elements (SFF1...SFFm) form a shift register which provides a scan path,
**characterized**
**in that** at least one electrically programmable protection element (SE), which either interrupts the relevant line or connects it to a defined potential, is arranged along the activation line (Scan Enable) and/or the data line sections (DL1 ...DLl).

2. Circuit arrangement according to Claim 1, **characterized in that** at least one protection element (SE) is a line section (Fuse) which can be disconnected electrically, and is arranged in the relevant line.

3. Circuit arrangement according to Claim 1 or 2, **characterized in that** at least one protection element (SE) is a line section (Anti-Fuse) which can be produced electrically and is arranged between the relevant line and the defined potential.

4. Circuit arrangement according to one of the preceding claims, **characterized in that** at least one protection element (SE) is formed with a logic gate which is arranged in the relevant line and whose second input can be irreversibly connected to a defined potential by means of a line section which can be disconnected or can be produced electrically, so that the gate is switched off.

## Revendications

1. Circuit avec un certain nombre de blocs fonctionnels (FB1 à FBn), dans lequel chacun des blocs fonctionnels est relié à au moins l'un des autres blocs fonctionnels et au moins un sous-ensemble de ces liaisons est réalisé à chaque fois par un élément de verrouillage (SFF1 à SFFm) qui peut être commuté par l'intermédiaire d'une ligne d'activation (Scan Enable) du mode normal à un mode de test et qui comporte une autre entrée de données et une autre sortie de données, ces autres entrées et sorties de données étant reliées entre elles au moyen de tronçons de ligne de données (DL1 à DLI) de telle sorte que les éléments de verrouillage (SFF1 à SFFm) forment un registre à décalage réalisant un chemin de balayage,
**caractérisé par le fait que**,
le long de la ligne d'activation (Scan Enable) et/ou des tronçons de ligne de données (DL1 à DLI), il y a au moins un élément de sécurité (SE) qui est programmable électriquement et qui interrompt la ligne concernée ou la relie à un potentiel défini.

2. Circuit selon la revendication 1, **caractérisé par le fait qu'**au moins un élément de sécurité (SE) est un tronçon de ligne pouvant être coupé électriquement (fusible) et est placé dans la ligne concernée.

3. Circuit selon la revendication 1 ou 2, **caractérisé par le fait qu'**au moins un élément de sécurité (SE) est un tronçon de ligne pouvant être généré électriquement (anti-fusible) et est placé entre la ligne concernée et le potentiel défini.

4. Circuit selon l'une des revendications précédentes, **caractérisé par le fait qu'**au moins un élément de sécurité (SE) est formé avec une porte logique qui est placée dans la ligne concernée et dont la deuxième entrée peut être mise à un potentiel défini au moyen d'un tronçon de ligne pouvant être coupé ou généré électriquement de telle sorte que la porte est bloquée.
